# EUROPÄISCHE PATENTANMELDUNG

(11) **EP 0 686 850 A1**
(43) Veröffentlichungstag der Anmeldung: **13.12.1995**
(21) Anmeldenummer: 95107297.4
(22) Anmeldetag: 13.05.1995
(51) Int. Cl.: G01R 19/20, G01R 15/18

(54) **Schaltungsanordnung zur Messung von Gleichströmen mit Potentialtrennung zwischen Stromkreis und Messkreis**

(30) Priorität: 09.06.1994 CH 1820/94
(71) Anmelder: LEM S.A., CH-1228 Plan-les-Ouates, Genève (CH)
(72) Erfinder: Alff, Jean-Jacques, Dipl.-Ing., CH-5634 Merenschwand (CH)
(74) Vertreter: OK pat AG

(57) **Zusammenfassung**

Mit dieser Schaltungsanordnung kann die durch die Offsetspannung verursachte Drift langfristig in engen zulässigen, vorbestimmten Grenzen gehalten werden. Zu diesem Zweck ist zwischen der Indikatorwicklung (**5**) und dem Eingang des Verstärkers (**7**) eine erste Umschalteinrichtung (**6**) vorgesehen, mittels welcher die Offsetspannung (**Uoff**) des Verstärkers (**7**) abwechselnd entweder direkt oder invertiert an die Indikatorwicklung (**5**) geschaltet werden kann. Zwischen dem Ausgang des Verstärkers (**7**) und der Sekundärwicklung (**4**) ist eine zweite Umschalteinrichtung (**8**) angeordnet, mit welcher die Richtung des Kompensationsstromes (**Iaus**) in der Sekundärwicklung (**4**) abwechselnd geändert werden kann. Die Umschalteinrichtungen (**6, 8**) sind mit einem Taktgeber verbunden, der ein Taktsignal (**T**) für die synchrone Betätigung der Umschalteinrichtungen (**6, 8**) erzeugt.

## Beschreibung

Die Erfindung betrifft eine Schaltungsanordnung zur Messung von Gleichströmen mit Potentialtrennung zwischen Stromkreis und Messkreis, mit einem Stromwandler, auf dessen Kern eine den zu messenden Strom führende Primärwicklung, eine einen Kompensationsstrom führende Sekundärwicklung und eine Indikatorwicklung angeordnet ist, in welcher durch eine Änderung des zu messenden Stromes eine Spannung induziert wird, sowie mit einem Verstärker, der eingangsseitig mit der Indikatorwicklung und ausgangsseitig mit der Sekundärwicklung und einem Bürdenwiderstand verbunden ist.

Derartige für Gleich- und/oder Wechselstrommessungen grosser Genauigkeit geeignete Schaltungsanordnungen arbeiten nach dem Nullflussprinzip. Hierbei wird mit einer Indikatorwicklung eines Messkreises, der von dem den zu messenden Strom führenden Stromkreis galvanisch getrennt ist, der Magnetfluss im Kern des Stromwandlers erfasst und auf einen möglichst kleinen Wert geregelt. Dies wird durch Einspeisung eines Kompensationsstromes in eine Sekundärwicklung des Messkreises erreicht, der das dem Magnetfluss entsprechende Integral der Spannung an der Indikatorwicklung auf Null regelt, und der ein Mass für den zu messenden Strom darstellt und zu diesem Zweck über einen Bürdenwiderstand beispielsweise in Form eines Amperemeters geführt wird.

Mit der Zeitschrift **etz Bd.100, 1979, Heft 24,** ist eine auch magnetischer Integrator genannte Schaltungsanordnung der vorstehend genannten Art bekannt geworden, bei der die Indikatorwicklung mit den Eingangsklemmen eines Verstärkers mit hohem Verstärkungsfaktor verbunden ist, dessen Ausgang den Bürdenwiderstand über die Sekundärwicklung speist. Der die Wicklungen tragende Kern ist ein Ringkern, der aus ferromagnetischem Material besteht. Durch jede Flussänderung im Kern, wie beispielsweise durch eine Änderung des zu messenden Stromes in der Primärwicklung bedingt, wird in der Indikatorwicklung eine Spannung induziert. Der Verstärker erzeugt in der Sekundärwicklung einen dieser Spannung entsprechenden, derart gepolten Kompensationsstrom, dass der Änderung des magnetischen Flusses im Kern entgegen gewirkt wird. Ein Nachteil des magnetischen Integrators ist darin zu sehen, dass auch die Offsetspannung des Verstärkers integriert wird und somit eine Drift entsteht. Dadurch nimmt der Fluss laufend zu, so dass der Kern nach einiger Zeit gesättigt und ein normaler Betrieb nicht mehr möglich ist. Dieser Nachteil lässt sich durch die Verwendung eines magnetischen Modulators vermeiden, mit dem eine Abweichnung des Flusses von Null festgestellt werden kann. Solche Modulatoren sind ziemlich aufwendig aufgebaut und daher teuer und benötigen mindestens zwei Kerne, wenn die Modulation den zu messenden Stromkreis nicht beeinflussen darf und soll.

Der Erfindung liegt daher die Aufgabe zugrunde eine Schaltungsanordnung der eingangs genannten Art vorzuschlagen, die vorstehend erwähnte Nachteile nicht aufweist und die insbesondere keinen Modulator benötigt.

Diese Aufgabe wird durch die im Patentanspruch **1** angegebene Erfindung gelöst. Hierbei ist zwischen der Indikatorwicklung und dem Eingang des Verstärkers eine erste Umschalteinrichtung vorgesehen, mittels welcher die Offsetspannung des Verstärkers abwechselnd entweder direkt oder invertiert an die Indikatorwicklung geschaltet werden kann. Zwischen dem Ausgang des Verstärkers und der Sekundärwicklung ist eine zweite Umschalteinrichtung angeordnet, mit welcher die Richtung des Kompensationsstromes in der Sekundärwicklung abwechselnd geändert werden kann. Die Umschalteinrichtungen sind mit einem Taktgeber verbunden, der ein Taktsignal für die synchrone Betätigung der Umschalteinrichtungen erzeugt.

Die mit der Erfindung erzielten Vorteile sind darin zu sehen, dass die zur Offsetspannung proportionale Drift sehr klein gehalten werden kann, so dass sie innerhalb bestimmter geforderter Genauigkeitsgrenzen zu liegen kommt. Da kein Modulator verwendet wird, ist der Aufwand geringer und die Rückwirkung auf den zu messenden Strom wird vermieden. Gemäss einer besonderen Ausführungsform kann der Kompensationsstrom in einer nachfolgenden Elektronik weiterverarbeitet werden. Der magnetische Integrator mit der erfindungsgemässen Umschaltung der Indikatorwicklung eignet sich für alle Messaufgaben mit Gleich- und/oder Wechselstrom, wobei insbesondere Fehlerstromerfassung und Differentialschutz mit hoher Empfindlichkeit gut realisiert werden kann, da normalerweise die Durchflutung Null ist und keine Leistung für das Speisen der Kompensationswicklung aufgewendet werden muss.

Im folgenden wird die Erfindung anhand mehrerer Ausführungsbeispiele in Verbindung mit der Zeichnung näher erläutert. Es zeigen:
- **Fig.1**: Ein Blockschaltschema der erfindungsgemässen Schaltungsanordnung in einer ersten Ausführungsform;
- **Fig.2**: ein Blockschaltschema der Schaltungsanordnung in einer zweiten Ausführungsform;
- **Fig.3**: ein Strom-Zeit-Diagramm des Kompensationsstromes der Schaltungsanordnung, wenn die Primärwicklung keinen Strom führt;
- **Fig.4**: eine schematische Darstellung eines ersten Anwendungsbeispieles der Schaltungsanordnung;
- **Fig.5**: eine schematische Darstellung eines zweiten Anwendungsbeispieles der Schaltungsanordnung, und
- **Fig.6**: eine schematische Darstellung eines dritten Anwendungsbeispieles der Schaltungsanordnung.

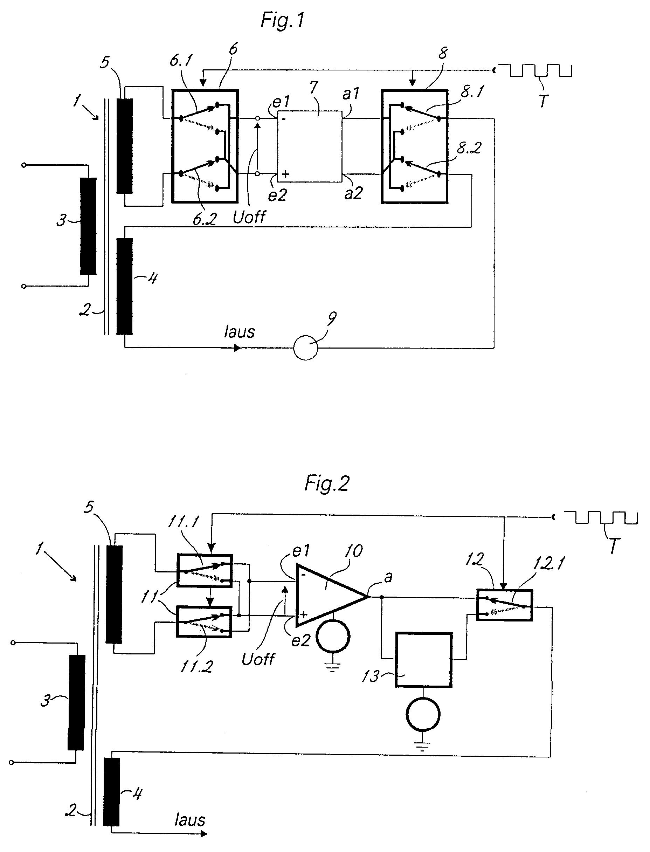

In der **Fig.1** ist mit **1** ein Stromwandler bezeichnet, auf dessen Kern **2** eine den zu messenden Strom führende Primärwicklung **3**, eine einen Kompensationsstrom Iaus führende Sekundärwicklung **4** und eine Indikatorwicklung **5** angeordnet ist, in welcher durch eine Änderung des zu messenden Stromes in der Primärwicklung **3** eine Spannung induziert wird. Der Kern **2** ist ein Ringkern, der aus ferromagnetischem Material besteht. Die Anschlüsse der Indikatorwicklung **5** sind über eine erste, zwei Umschalter **6.1, 6.2** aufweisende Umschalteinrichtung **6** mit den Eingängen **e1, e2** eines Verstärkers **7** verbunden, der ein als Regler arbeitender Operationsverstärker ist. Mittels der ersten Umschalteinrichtung **6** können die Anschlüsse der Indikatorwicklung **5** abwechselnd an den einen oder den anderen Eingang **e1, e2** des Verstärkers **7** geschaltet werden, so dass die Offsetspannung Uoff des Verstärkers **7** direkt oder invertiert an die Indikatorwicklung **5** gelegt wird. Die Anschlüsse der Sekundärwicklung **4** sind über eine zweite, zwei Umschalter **8.1, 8.2** aufweisende Umschalteinrichtung **8** und einen Bürdenwiderstand beispielsweise in Form eines Amperemeters **9** mit einem ersten Ausgang **a1** und einem zweiten Ausgang **a2** des Verstär-kers **7** verbunden. Mittels der zweiten Umschalteinrichtung **8**, die synchron mit der ersten Umschaltvorrichtung **6** betrieben wird, können die Anschlüsse der Sekundärwicklung **4** abwechselnd an den ersten Ausgang **a1** oder den zweiten Anschluss **a2** des Verstärkers **7** geschaltet werden. Weil gleichzeitig Eingänge und Ausgänge des Verstärkers umgeschaltet werden, bleibt der Regelsinn für die Kompensation erhalten. Der Strom **Iaus** wechselt weder Vorzeichen noch Wert beim Schalten. Die Ströme an den Ausgängen **a1** und **a2**, die zueinander komplementär sind, wechseln hingegen das Vorzeichen im Umschaltmoment.
Die Umschalteinrichtungen **6**, **8** sind mit einem nicht weiter dargestellten und beschriebenen Taktgeber verbunden, der ein Taktsignal **T** für die synchrone Betätigung beider Umschalteinrichtungen **6**, **8** erzeugt. Als Umschalteinrichtungen können beispielsweise Mosfets oder andere Halbleiterschalter sowie Fotowiderstände und mechanische bzw. elektromechanische Schalter verwendet werden.

Gemäss **Fig.2** sind die Anschlüsse der Indikatorwicklung **5** in gleicher Weise und zu gleichem Zweck wie in **Fig.1** über eine erste, zwei Umschalter **11.1**, **11.2** aufweisende Umschalteinrichtung **11** an den Eingängen **e1**, **e2** eines Verstärkers **10** angeschlossen, der ein als Regler arbeitender Operationsverstärker ist. Der eine Anschluss der Sekundärwicklung **4** ist über eine lediglich einen Umschalter **12.1** aufweisende zweite Umschalteinrichtung **12** direkt, sowie über die zweite Umschalteinrichtung **12** und einen Inverter **13** mit dem Ausgang **a** des Verstärkers **10** verbunden. Mittels der zweiten Umschalteinrichtung **12** kann der eine Anschluss der Sekundärwicklung **4** abwechselnd direkt oder über den Inverter **13** an den Ausgang **a** des Verstärkers **10** geschaltet werden, so dass die Richtung des Kompensationsstromes **Iaus** in der Sekundärwicklung **4** im Umschalttakt ständig gewechselt wird. Der andere Anschluss der Sekundärwicklung **4** ist mit einem weiteren, nicht dargestellten Strom/Spannungswandler verbunden, wobei dessen Bürdenwiderstand bzw. Amperemeter oder virtuelle Erde, die den Kompensationsstrom **Iaus** weiterverarbeiten, gegen Erde betrieben werden kann (**Fig.5,6**).
Der Stromkreis des Kompensationsstromes **Iaus** ist geschlossen über die gegen Erde betriebenen Stromversorgungen von Verstärker **10** und Inverter **13**.

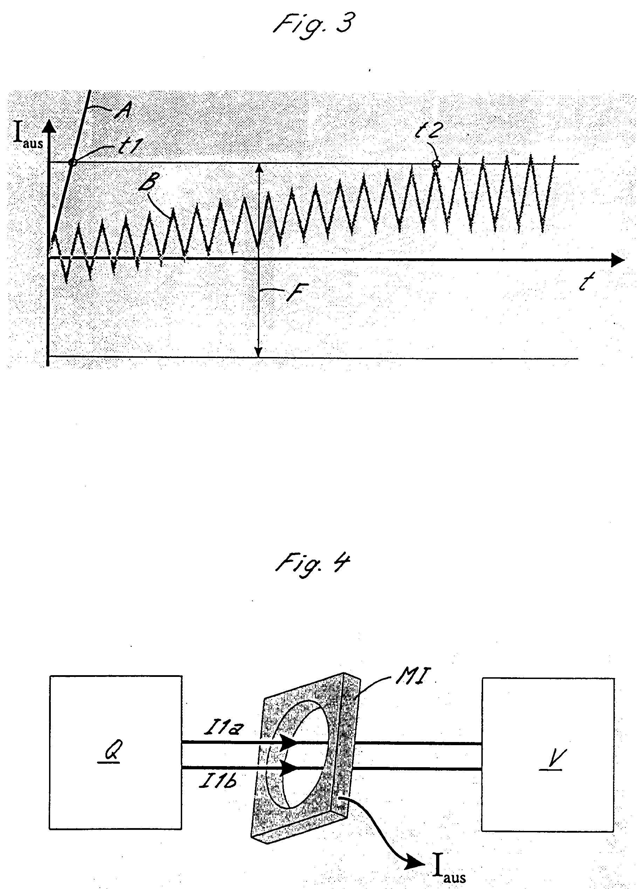

In der **Fig.3** zeigt eine Kennlinie **A** den zeitlichen Verlauf des Kompensationsstromes **Iaus** bzw. der durch die Offsetspannung **Uoff** verursachten momentanen Drift ohne die Umschalteinrichtungen **6**, **8, 11, 12,** und eine Kennlinie **B** den Verlauf mit den Umschalteinrichtungen **6, 8, 11, 12**. Mit **F** ist eine Zulässige Fehlerbandbreite bezeichnet, die beispielsweise +/- 1 mA betragen kann. In einem ersten Zeitpunkt **t1** würde die Kennlinie **A** die zulässige Fehlerbandbreite **F** überschreiten, während die Kennlinie **B** die Fehlerbandbreite **F** erst zu einem zweiten, wesentlich späteren Zeitpunkt **t2** überschreitet.

Die Offsetspannung **Uoff** des Verstärkers **7** bzw. **10**, die anfänglich auf Null abgeglichen wird, kann durch Alterung, Herstellungsfehler, Temperatur usw. wieder von Null abweichende Werte annehmen, so dass eine Drift entsteht. Da die Offsetspannung **Uoff** sich dabei relativ langsam ändert, kann man die Drift wieder rückgängig machen, indem die Umschalteinrichtungen **6, 8, 11, 12** in gleich langen durch das Taktsignal **T** gegebenen Zeitabständen abwechselnd in die eine oder andere Stellung geschaltet werden. Im Idealfall, wenn die Umschalteinrichtungen **6, 8, 11, 12** keine Spannungsdifferenzen aufweisen würden, wäre die mittlere Drift Null, auch wenn die Offsetspannung **Uoff** einen unbekannten, von Null abweichenden Wert aufweisen würde. Da die bekannten Schalter Spannungsdifferenzen aufweisen, die allerdings um Grössenordnungen kleiner als die Offsetspannungen bekannter Verstärker sind, kann trotz der ständigen Richtungsumkehr des Kompensationsstromes **Iaus** der Fluss im Kern nicht ganz auf Null geregelt werden, so dass die Drift wenn auch erst nach relativ langer Zeit, beispielsweise nach einem Jahr, die zulässige Fehlerbandbreite überschreitet (**t2**, **Fig.3**).

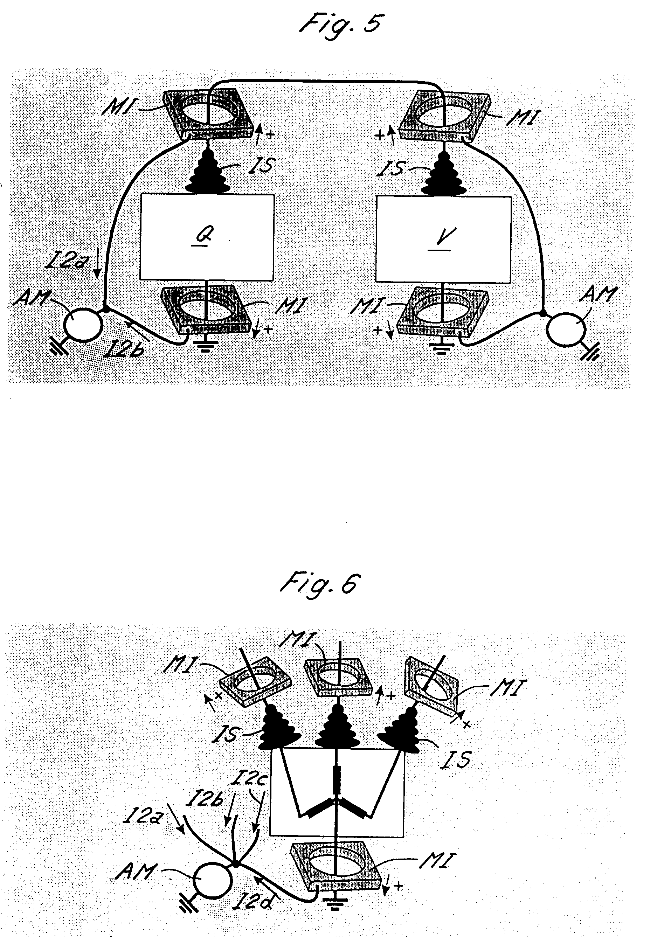

Gemäss **Fig.4** ist eine Quelle **Q** über die Primärwicklung **3** des in den **Fig.1**, **2** beschriebenen magnetischen Integrators **MI** mit einem Verbraucher **V** verbunden. Eine derartige Anordnung kann vorteilhaft als empfindlicher Fehlerstromdetektor für Gleich- und Wechselstrombetrieb angewendet werden. Hierbei ist der Kompensationsstrom **Iaus** ein Mass für die Ströme **I1a + I1b** und ist normalerweise Null.

In der **Fig.5** sind mit **IS** Isolatoren und mit **AM** Amperemeter bezeichnet. Die gute Reproduzierbarkeit des Übertragungsverhältnisses der in der **Fig.2** beschriebenen magnetischen Integratoren **MI** ermöglicht es, dass diese Anordnung als empfindlicher Differentialschutz für Gleich- und Wechselstrombetrieb eingesetzt werden kann. Solange z.B. kein Isolationsdefekt in der Quelle **Q** vorliegt, ist **I2a** gleich -**I2b**, so dass die Summe beider Ströme gleich Null ist.

Die Anordnung gemäss **Fig.6** zeigt eine weitere Schaltung für die Fehlerdetektion. Die Summe der vier Ströme **I2a** bis **I2d** ist Null, wenn kein Isolationsdefekt vorliegt.

## Patentansprüche

1. Schaltungsanordnung zur Messung von Gleichströmen mit Potentialtrennung zwische Stromkreis und Messkreis, mit einem Stromwandler (**1**), auf dessen Kern (**2**) eine den zu messenden Strom führende Primärwicklung (**3**), eine einen Kompensationsstrom (**Iaus**) führende Sekundärwicklung (**4**) und eine Indikatorwicklung (**5**) angeordnet ist, in welcher durch eine Änderung des zu messenden Stromes eine Spannung induziert wird, sowie mit einem Verstärker (**7**, **10**), der eingangsseitig mit der Indikatorwicklung (**5**) und ausgangsseitig mit der Sekundärwicklung (**4**) und einem Bürdenwiderstand (**9**) verbunden ist,
**dadurch gekennzeichnet**, dass
- der Verstärker (**7**, **10**) eingangsseitig über eine erste Umschalteinrichtung (**6**, **11**) derart mit der Indikatorwicklung (**5**) verbunden ist, dass die Offsetspannung (**Uoff**) des Verstärkers (**7**, **10**) abwechselnd entweder direkt oder invertiert an die Indikatorwicklung (**5**) geschaltet werden kann,
- der Verstärker (**7**, **10**) ausgangsseitig über eine zweite Umschalteinrichtung (**8**, **12**) derart mit der Sekundärwicklung (**4**) verbunden ist, dass die Richtung des Kompensationsstromes (**Iaus**) in der Sekundärwicklung (**4**) abwechselnd geändert werden kann,
und
- die Umschalteinrichtungen (**6, 8, 11, 12**) mit einem Taktgeber verbunden sind, der ein Taktsignal (**T**) für die synchrone Betätigung der Umschalteinrichtungen (**6, 8, 11, 12**) erzeugt.

2. Schaltungsanordnung nach Anspruch **1**,
**dadurch gekennzeichnet**, dass
- die erste Umschalteinrichtung (**6**) zwei Umschalter (**6.1**, **6.2**) aufweist, wobei die Anschlüsse der Indikatorwicklung (**5**) abwechselnd an den einen oder den anderen Eingang (**e1**,**e2**) des Verstärkers (**7**) geschaltet werden,
und
- die zweite Umschalteinrichtung (**8**) zwei Umschalter (**8.1**, **8.2**) aufweist, wobei die Anschlüsse der Sekundärwicklung (**4**) abwechselnd an einen Ausgang (**a**) oder einen Masseanschluss (**m**) des Verstärkers (**7**) geschaltet werden.

3. Schaltungsanordnung nach Anspruch **1**,
**dadurch gekennzeichnet**, dass
- die erste Umschalteinrichtung (**11**) zwei Umschalter (**11.1**, **11.2**) aufweist, wobei die Anschlüsse der Indikatorwicklung (**5**) abwechselnd an den einen oder den anderen Eingang (**e1**, **e2**) des Verstärkers (**10**) geschaltet werden,
und
- die zweite Umschalteinrichtung (**12**) einen Umschalter (**12.1**) aufweist und direkt sowie über einen Inverter (**13**) mit einem Ausgang (**a**) des Verstärkers (**10**) verbunden ist, wobei der eine Anschluss der Sekundärwicklung (**4**) abwechselnd direkt oder über den Inverter (**13**) an den Ausgang (**a**) geschaltet wird.

4. Schaltungsanordnung nach Anspruch **3**,
**dadurch gekennzeichnet**, dass der andere Anschluss der Sekundärwicklung (**4**) zwecks Weiterverarbeitung des Kompensationsstromes (**Iaus**) mit einem weiteren Stromwandler verbindbar ist.

5. Schaltungsanordnung nach Anspruch **1**,
**dadurch gekennzeichnet**, dass die Umschalteinrichtungen (**6, 8, 11, 12**) aus Mosfets oder anderen Halbleiterschaltern bestehen.

6. Schaltungsanordnung nach Anspruch **1**,
**dadurch gekennzeichnet**, dass die Umschalteinrichtungen (**6, 8, 11, 12**) aus mechanischen bzw. elektromechanischen Schaltern bestehen.
